# EUROPÄISCHE PATENTSCHRIFT

(11) **EP 0 309 878 B1**
(45) Veröffentlichungstag und Bekanntmachung des Hinweises auf die Patenterteilung: **09.03.1994**
(21) Anmeldenummer: 88115438.9
(22) Anmeldetag: 21.09.1988
(51) Int. Cl.: H03J 9/06, G11B 31/00, H04B 1/20

(54) **Programmierverfahren und/oder -Einrichtung für Audio- oder Videogeräte**
Method and/or device for programming audio or video apparatuses
Procédé et/ou dispositif de programmation pour appareils audio ou vidéo

(30) Priorität: 30.09.1987 DE 3733015
(43) Veröffentlichungstag der Anmeldung: 05.04.1989
(73) Patentinhaber: Deutsche Thomson-Brandt GmbH, 78003 Villingen-Schwenningen (DE)
(72) Erfinder: Eigeldinger, Norbert, D-7730 VS-Villingen (DE); Fechner, Rainer, D-7730 Villingen (DE)
(74) Vertreter: Einsel, Robert, Dipl.-Ing.

(56) Entgegenhaltungen:
- WO-A-87/03766
- RUNDFUNKTECHNISCHE MITTEILUNGEN, Jahrgang 26, 1982, Heft 6, Seiten 254-257, Hamburg, DE; G. HOFMANN et al.: "Videotext programmiert Videorecorder"

## Beschreibung

Die Erfindung betrifft ein Verfahren und eine Einrichtung zum Programmieren eines Audio- oder Videogerätes nach dem Oberbegriff des Anspruchs 1 bzw. des Anspruchs 6.

Verfahren der eingangs genannten Art sind insbesondere bei Videorecordern bekannt. Dabei werden - meist beim erstmaligen Anschließen des Recorders an eine bestehende Videoanlage - einzelnen sogenannten Programmnummern oder Programmplätzen des Recorders jeweils eine Frequenz oder ein Kanal örtlich empfangbarer Rundfunksender zugeordnet und in einem sogenannten Programmspeicher gespeichert. Der Recorder wird also mit einem bestimmten "Grundwissen" gefüllt oder "programmiert". Soll der Tuner des Recorders dann auf einen auf einen gewünschten Sender abgestimmt werden, so braucht der Benutzer nicht mehr die betreffende Sendefrequenz oder Kanalnummer einzugeben, die er häufig gar nicht auswendig weiß; es genügt vielmehr, daß er die zugeordnete Programmnummer eingibt. Über den Programmspeicher ermittelt der Recorder dann die dem gewünschten Programm zugehörige Sendefrequenz oder Kanalnummer und stimmt den Tuner entsprechend ab.

Bei dem bekannten Verfahren ist es jedoch von Nachteil, daß das Eingeben der Frequenzen und deren Zuordnen zu einzelnen Programmnummern zeitraubend und fehleranfällig ist.

Eine Quelle zusätzlicher Fehlbedienungen kann außerdem noch dann auftreten, wenn die einzelnen Komponenten einer Audio- oder Videoanlage - beispielsweise Hörfunk- oder Fernsehempfangsgerät und Videorecorder - unterschiedliche Zuordnungen von Frequenzen oder Kanälen zu Programmnummern aufweisen.

Der Erfindung liegt die Aufgabe zugrunde, ein für den Benutzer einfaches Programmieren von Audio- oder Videogeräten mit zum Empfang von Fernseh- und/oder Hör-Rundfunksendern benötigten Abstimmdaten zu ermöglichen.

Diese Aufgabe wird durch die in Anspruch 1 aufgeführten Maßnahmen gelöst. Diese Aufgabe wird auch durch die in Anspruch 6 aufgeführten Maßnahmen gelöst. Nach der Erfindung werden die Abstimm-Daten und deren Zuordnung zu einer Programmnummer oder -Kennzeichnung automatisch einem Programmspeicher eines bereits programmierten Audio- oder Videogerätes entnommen.

In einem typischen Anwendungsfall ist ein vorhandenes Fernsehempfangsgerät bereits auf manuelle Weise programmiert worden. Ein nun zusätzlich installierter Videorecorder wird erfidungsgemäß dadurch programmiert, daß die im Programmspeicher des Fernsehempfangsgerätes gespeicherten Abstimm-Daten und deren Zuordnung zu einer Programmnummer oder -Kennzeichnung automatisch entnommen und zu dem Programmspeicher des Videorecorders übertragen werden. Dieses Übertragen erfolgt vorzugsweise mittels einer Infrarot-Strecke.

Ist im einen Gerät, also beispielsweise im Fernsehempfangsgerät, Zugriff auf einen Videotextdecoder gegeben, so kann die über das Videotextsystem empfangene augenblickliche Uhrzeit ebenfalls dem zu programmierenden Gerät zugeführt werden, um dessen geräteeigene Uhr auf die aktuelle Uhrzeit richtig einzustellen.

Das übertragen der Daten kann in der Weise erfolgen, daß ein bei einen fernbedienbaren Audio- oder Videogerät ohnehin vorgesehenes Fernbedienungsübertragungsverfahren verwendet wird. Werden beispielsweise die zum Programmieren benötigten Daten einer an dem Fernsehempfangsgerät angeordneten Infrarot-Sendeeinheit in geeigneter Weise zugeführt, kann so für das zu programmierende Gerät ein Programmieren über den ihm zugeordneten manuellen Infrarot-Fernbedienungsgeber simuliert werden. Dies hat den Vorteil, daß an dem automatisch zu programmierenden Gerät, also beispielsweise am oben erwähnten Videorecorder, keine zusätzlichen Vorkehrungen zu treffen sind.

Der Benutzer kann ferner - etwa beim manuell ausgeführten erstmaligen oder erneuten Programmieren des einen Gerätes - von der Ablaufsteuerung der Infrarot-Sendeeinheit aufgefordert werden, den Typ des automatisch zu programmierenden Audio- oder Videogerätes einzugeben. Ist das manuell programmierte Gerät ein Fernsehempfangsgerät, so kann eine solche Aufforderung beispielsweise so geschehen, daß in einer am Bildschirm des Fernsehempfangsgerätes eingeblendeten Vorschlagsliste mittels eines Cursors eine Auswahl zu treffen ist. Einem Speicher, in dem eine Zuordnung von einzelnen Typen von Audio- oder Videogeräten zu deren Fernbedienungsübertragungsverfahren gespeichert ist, kann die Infrarot-Sendeeinheit dann das geeignete Übertragungsformat entnehmen.

Vorteilhafte Weiterbildungen der Erfindung sind in den Unteransprüchen beschrieben.

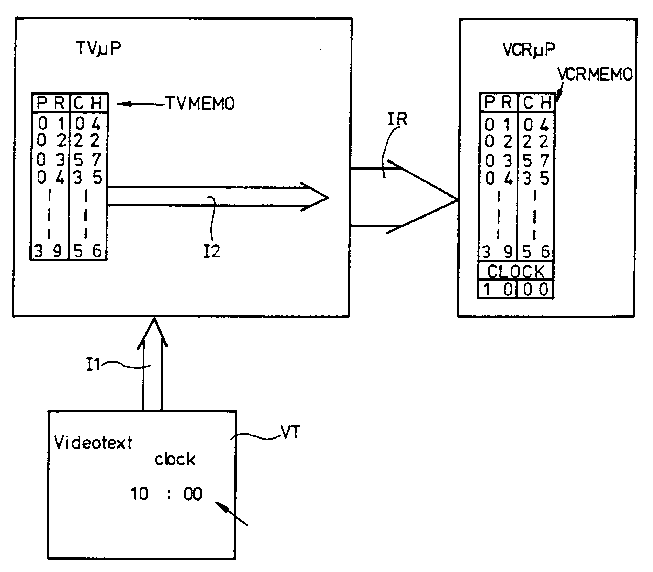

Weitere Vorteile, Merkmale und Einzelheiten der Erfindung werden im folgenden an einem bevorzugten Ausführungsbeispiel anhand der Zeichnung erläutert, die in einem stark vereinfachten Blockschaltbild einen einem nicht dargestellten Fernsehempfangsgerät zugeordneten ersten Mikroprozessor (TVµP) zeigt, von dem über eine Infrarot-Strecke (IR) Informationen zu einem einem nicht dargestellten Videorecorder zugeordneten zweiten Mikroprozessor (VCRµP) übertragen werden.

Sowohl der erste als auch der zweite Mikroprozessor (TVµP) bzw. (VCRµP) weisen einen sogenannten Programmspeicher (TVMEMO) bzw. (VCRMEMO) auf, in denen zu jeder dort vorgesehenen Programmnummer (PR) ein gewünschter Kanal (CH) eingegeben werden kann, auf den der betreffende Tuner bei Aufruf der Programmnummer (PR) abgestimmt werden soll. Beispielsweise ist bei Aufruf der Programmnummer (PR01) auf den Kanal (CH04), der Programmnummer (PR02) auf den Kanal (CH22), der Programmnummer (PR03) auf den Kanal (CH57) usw. abzustimmen.

Der Programmspeicher (VCRMEMO) des Videorecorders weist außerdem noch einen für die aktuelle Uhrzeit reservierten Speicherplatz (CLOCK) auf.

Eine Videotext-Decodereinrichtung (VT), die im dargestellten Beispiel aus empfangenen Signalen soeben - wie ersichtlich - die aktuelle Uhrzeit 10:00 decodiert, symbolisch mit "Videotext clock" angedeutet, ist über einen sogenannten I²C-Bus (I1) an den ersten Mikroprozessor (TVµP) angeschlossen, dem sie über diesen I²C-Bus (I1) die aktuelle Uhrzeit übermittelt. Von dort wird die aktuelle Uhrzeit ebenfalls über die Infrarot-Strecke (IR) zum zweiten Mikroprozessor (VCRµP) übertragen, in dessen Programmspeicher (VCRMEMO) sie auf dem Speicherplatz (CLOCK) abgelegt wird und sodann zum richtigen Einstellen einer nicht dargestellten, dem Videorecorder zugeordneten elektronischen Uhr dient.

Im ersten Mikroprozessor (TVµP) ist schematisch ein Datenweg (I2), ausgehend vom Programmspeicher (TVMEMO) und hinführend zum Ausgangspunkt der Infrarot-Strecke (IR), angedeutet. Aus dem Programmspeicher (TVµP) ausgelesene Daten werden über diesen Datenweg (I2), beispielsweise eine einem Treibertransistor für eine Infrarot-Sendediode zugeführte Signalleitung, einer nicht dargestellten Infrarot-Sendeeinheit zugeleitet. Die ausgesandten Signale werden in bekannter Weise am anderen Ende der Infrarot-Übertragungsstrecke (IR) von einer nicht dargestellten Infrarot-Empfangseinheit empfangen und von dort schließlich dem Programmspeicher (VCRMEMO) des Videorecorders zugeführt.

Im dargestellten Beispiel war der Benutzer bereits aufgefordert worden, den für die Infrarot-Strecke (IR) gewünschten Übertragungscode einzugeben, wobei - hier im einzelnen nicht ausgeführt - der für den schon ohnehin fernbedienbaren Vidoerecorder gültige Fernbedienungscode gewählt wurde, der im vorliegenden Fall in einem nicht dargestellten Festwertspeicher des ersten Mikroprozessors (TVµP) auf Abruf bereitstand. Hierauf wurde dann über die interne Ablaufsteuerung des ersten Mikroprozessors (TVµP) automatisch das Auslesen seines Programmierspeichers (TVMEMO) und das Abfragen der über den I²C-Bus (I1) angelieferten aktuellen Uhrzeit sowie das Aussenden aller dieser Informationen mittels der Infrarot-Sendeeinheit veranlaßt. Im dargestellten Beispiel sind diese Informationen - wie ersichtlich - bereits bis zu den hierfür vorgesehenen Speicherplätzen im Programmspeicher (VCRMEMO) des Videorecorders erfolgreich, das heißt fehlerfrei weitergeleitet worden. Dort stehen sie nun in derselben Zuordnung von Programmnummern zu Abstimmkanälen zur Verfügung, wie dies bei dem Fernsehempfangsgerät der Fall ist.

Diese Gleichartigkeit der Zuordnung hat nicht nur für den technisch weniger versierten Benutzer die oben geschilderten Bedienungserleichterungen zum Vorteil. Auch etwa der berufsmäßig mit solchen Geräten arbeitende Benutzer kann entlastet werden. Ist beispielsweise bei Ausstellungen, Messen oder dgl. eine größere Anzahl von Geräten zu programmieren, so genügt es, wenn eines davon erfindungsgemäß ausgebildet ist. Nach erfolgtem manuellen Programmieren dieses einen Gerätes können dann die übrigen Geräte in der beschriebenen Weise automatisch programmiert werden, wobei - genügende Sendeleistung beispielsweise der Infrarot-Sendeeinheit und geeigneter Übertragungscode vorausgesetzt - alle übrigen Geräte in einem einzigen Zug automatisch programmiert werden.

## Patentansprüche

1. Verfahren zum Programmieren eines Audio- oder Videogerätes, insbesondere eines Videorecorders, mit zum Empfang von Fernseh- und/oder Hör-Rundfunksendern benötigten Abstimm-Daten (Kanal, Frequenz o. dgl.), wobei die einen Sender betreffenden Abstimm-Daten unter Zuordnung zu einer Programmnummer oder -Kennzeichnung in einen Programmspeicher (VCRMEMO) des Audio- oder Videogerätes eingebbar sind, dadurch gekennzeichnet, daß die Abstimm-Daten und deren Zuordnung zu einer Programmnummer oder -Kennzeichnung automatisch durch Auslesen aus einem Programmspeicher (TVMEMO) eines bereits programmierten Audio- oder Videogerätes, insbesondere eines Fernsehempfangsgerätes, entnommen werden, daß diese Informationen drahtlos oder drahtgebunden von dem bereits programmierten zu dem zu programmierenden Gerät übertragen werden und daß die übertragenen Informationen in den Programmspeicher (VCRMEMO) des zu programmierenden Gerätes eingespeichert werden.

2. Verfahren nach Anspruch 1, dadurch gekennzeichnet, daß das übertragen über eine Infrarot-Strecke (IR) erfolgt.

3. Verfahren nach Anspruch 1 oder 2, dadurch gekennzeichnet, daß als Übertragungscode derselbe Code zur Anwendung gelangt, wie er für eine dem zu programmierenden Gerät zugeordnete Fernbedienung vorgesehen ist.

4. Verfahren nach einem der Ansprüche 1 - 3, dadurch gekennzeichnet, daß bei einem manuell erfolgenden Programmieren des einen Gerätes eine Eingabemöglichkeit vorgesehen ist, nach deren Aktivieren ein vorbestimmtes oder zu bezeichnendes anderes Gerät automatisch mit den im Programmspeicher des einen Gerätes enthaltenen Informationen bezüglich der Abstimm-Daten und deren Zuordnung zu den jeweiligen Programmnummern oder -Kennzeichnungen programmiert wird.

5. Verfahren nach einem der Ansprüche 1 bis 4, dadurch gekennzeichnet, daß zusätzlich zu den Informationen bezüglich der Abstimm-Daten und deren Zuordnung zu den jeweiligen Programmnummern oder -Kennzeichnungen die mittels einer Videotext-Decodereinheit (VT) empfangene augenblickliche Uhrzeit zu dem zu programmierenden Gerät übertragen wird und zum Einstellen dessen geräteeigener Uhr dient.

6. Einrichtung zum Programmieren eines Audio- oder Videogerätes, insbesondere eines Videorecorders, mit zum Empfang von Fernseh- und/oder Hör-Rundfunksendern benötigten Abstimm-Daten (Kanal, Frequenz o. dgl.), wobei die einen Sender betreffenden Abstimm-Daten unter Zuordnung zu einer Programmnummer oder -Kennzeichnung in einen Programmspeicher (VCRMEMO) des Audio- oder Videogerätes eingebbar sind, dadurch gekennzeichnet, daß zwischen einem Programmspeicher (TVMEMO) eines bereits programmierten Audio- oder Videogerätes, insbesondere eines Fernsehempfangsgerätes, und dem Programmspeicher (VCRMEMO) des zu programmierenden Gerätes eine drahtlose (IR) oder drahtgebundene (I2) Übertragungsstrecke vorgesehen ist, über die die Abstimm-Daten und deren Zuordnung zu einer Programmnummer oder -Kennzeichnung automatisch von dem bereits programmierten zu dem zu programmierenden Gerät übertragen werden.

7. Einrichtung nach Anspruch 6, dadurch gekennzeichnet, daß das übertragen über eine Infrarot-Strecke (IR) erfolgt.

8. Einrichtung nach Anspruch 6 oder 7, dadurch gekennzeichnet, daß als Übertragungscode derselbe Code zur Anwendung gelangt, wie er für eine dem zu programmierenden Gerät zugeordnete Fernbedienung vorgesehen ist.

9. Einrichtung nach einem der Ansprüche 6 - 8, dadurch gekennzeichnet, daß bei einem manuell erfolgenden Programmieren des einen Gerätes eine Eingabemöglichkeit vorgesehen ist, nach deren Aktivieren ein vorbestimmtes oder zu bezeichnendes anderes Gerät automatisch mit den im Programmspeicher des einen Gerätes enthaltenen Informationen bezüglich der Abstimm-Daten und deren Zuordnung zu den jeweiligen Programmnummern oder -Kennzeichnungen programmiert wird.

10. Einrichtung nach einem der Ansprüche 6 bis 9, dadurch gekennzeichnet, daß zusätzlich zu den Informationen bezüglich der Abstimm-Daten und deren Zuordnung zu den jeweiligen Programmnummern oder -Kennzeichnungen die mittels einer Videotext-Decodereinheit (VT) empfangene augenblickliche Uhrzeit zu dem zu programmierenden Gerät übertragen wird und zum Einstellen dessen geräteeigener Uhr dient.

## Claims

1. A method for the programming of an audio or video appliance, especially a videorecorder, with tuning data required for the reception of television and/or radio broadcast transmitters (channel, frequency or the like), in which the tuning data concerning a transmitter can be fed to a programme memory (VCRMEMO) of the audio or video appliance whilst being assigned to a programme number or identification, characterised in that the tuning data and their assignment to a programme number or identification are loaded automatically during read out from a programme memory (TVMEMO) of an already-programmed audio or video appliance especially a television set, that this information is transferred with or without wires from the already-programmed appliance to the appliance to be programmed and that the transferred information is stored in the programme memory (VCRMEMO) of the appliance to be programmed.

2. A method according to claim 1, characterised in that the transfer occurs via an infra-red path (IR).

3. A method according to claim 1 or 2, characterised in that there is used as the transfer code the same code as is provided for a remote control belonging to the appliance to be programmed.

4. A method according to any one of claims 1 to 3 characterised in that during a manual programming of a first appliance there is provided an input option, after actuation of which another appliance, which is predetermined or is to be designated, is automatically programmed with the information contained in the programme memory of the first device concerning the tuning data and their assignment to the respective programme numbers or identifications.

5. A method according to any of claims 1 to 4, characterised in that in addition to the information concerning the tuning data and their assignment to the respective programme numbers or identifications, there is transferred to the appliance to be programmed the current time received by means of a videotext decoder unit (VT) which serves to set the appliance's own clock.

6. A device for the programming of an audio or video appliance, especially a video recorder, with tuning data required for the reception of television and/or radio broadcast transmitters (channel, frequency or the like), in which the tuning data concerning a transmitter can be fed to a programme memory (VCRMEMO) of the audio or video appliance whilst being assigned to a programme number or identification, characterised in that there is provided between a programme memory (TVMEMO) of an already-programmed audio or video appliance, especially a television set, and the programme memory (VCRMEMO) of the appliance to be programmed, a transfer path without wires (IR) or with wires (I2), via which are automatically transferred the tuning data and their assignment to a programme number or identification from the already-programmed appliance to the device to be programmed.

7. A device according to claim 6, characterised in that the transfer occurs via an infra-red path (IR).

8. A device according to claim 6 or 7, characterised in that there is used as the transfer code the same code as is provided for a remote control belonging to the appliance to be programmed.

9. A device according to any one of claims 6 to 8, characterised in that during a manual programming of a first appliance there is provided an input option, after actuation of which another appliance, which is predetermined or is to be designated, is automatically programmed with the information contained in the programme memory of the first device concerning the tuning data and their assignment to the respective programme numbers or identifications.

10. A device according to any one of claims 6 to 9, characterised in that in addition to the information concerning the tuning data and their assignment to the respective programme numbers of identifications, there is transferred to the appliance to be programmed the current time received by means of a video decoder unit (VT) which serves to set the appliance's own clock.

## Revendications

1. Procédé pour la programmation d'un appareil audio ou vidéo, en particulier d'un magnétoscope, avec des données d'accord (canal, fréquence ou équivalent) requises pour la réception d'émetteurs de télévision et/ou de radio, les données d'accord qui concernent un émetteur pouvant être entrées dans une mémoire de programme (VCRMEMO) de l'appareil audio ou vidéo en étant affectées à un numéro ou à une identification de programme, **caractérisé en ce** que les données d'accord et leur affectation à un numéro ou à une identification de programme sont automatiquement prises par extraction d'une mémoire de programme (TVMEMO) d'un appareil audio ou vidéo déjà programmé, en particulier d'un récepteur de télévision, que ces informations sont transférées sans fil ou avec fil par l'appareil déjà programmé à l'appareil à programmer et que les informations transmises sont mises en mémoire dans la mémoire de programme (VCRMEMO) de l'appareil à programmer.

2. Procédé selon la revendication 1, **caractérisé en ce** que le transfert se fait par un trajet à infrarouge (IR).

3. Procédé selon la revendication 1 ou 2, **caractérisé en ce** que le même code qui est prévu pour une télécommande affectée à l'appareil à programmer est utilisé comme code de transmission.

4. Procédé selon l'une des revendications 1 à 3, **caractérisé en ce** qu'il est prévu, pour une programmation de l'un des appareils qui a lieu manuellement, une possibilité d'entrée après l'activation de laquelle un autre appareil prédéterminé ou à désigner est programmé automatiquement avec les informations contenues dans la mémoire de programme de l'un des appareils en ce qui concerne les données d'accord et leur affectation aux programmes ou identifications de programme respectives.

5. Procédé selon l'une des revendications 1 à 4, **caractérisé en ce** qu'en plus des informations au sujet des données d'accord et de leur affectation aux programmes ou identifications de programme respectives l'heure momentanée reçue par une unité de décodage de vidéotexte (VT) est transférée à l'appareil à programmer et sert à régler l'horloge interne de celui-ci.

6. Dispositif pour programmer un appareil audio ou vidéo, en particulier d'un magnétoscope, avec des données d'accord (canal, fréquence ou équivalent) requises pour la réception d'émetteurs de télévision et/ou de radio, les données d'accord qui concernent un émetteur pouvant être entrées dans une mémoire de programme (VCRMEMO) de l'appareil audio ou vidéo en étant affectées à un numéro ou à une identification de programme, **caractérisé en ce** qu'il est prévu un trajet de transmission sans fil (IR) ou sans fil (I2) entre une mémoire de programme (TVMEMO) d'un appareil audio ou vidéo déjà programmé, en particulier d'un récepteur de télévision, et la mémoire de programme (VCRMEMO) de l'appareil à programmer, trajet par lequel les données d'accord et leur affectation à un numéro ou à une identification de programme sont automatiquement transférées par l'appareil déjà programmé à l'appareil à programmer.

7. Dispositif selon la revendication 6, **caractérisé en ce** que le transfert se fait par un trajet à infrarouge (IR).

8. Dispositif selon la revendication 6 ou 7, **caractérisé en ce** que le même code qui est prévu pour une télécommande affectée à l'appareil à programmer est utilisé comme code de transmission.

9. Dispositif selon l'une des revendications 6 à 8, **caractérisé en ce** qu'il est prévu, pour une programmation de l'un des appareils qui a lieu manuellement, une possibilité d'entrée après l'activation de laquelle un autre appareil prédéterminé ou à désigner est programmé automatiquement avec les informations contenues dans la mémoire de programme de l'un des appareils en ce qui concerne les données d'accord et de leur affectation aux programmes ou identifications de programme respectives.

10. Dispositif selon l'une des revendications 6 à 9, **caractérisé en ce** qu'en plus des informations au sujet des données d'accord et de leur affectation aux programmes ou identifications de programme respectives l'heure momentanée reçue par une unité de décodage de vidéotexte (VT) est transmise à l'appareil à programmer et sert à régler l'horloge interne de celui-ci.
